# EUROPÄISCHE PATENTSCHRIFT

(11) **EP 3 012 861 B1**
(45) Veröffentlichungstag und Bekanntmachung des Hinweises auf die Patenterteilung: **15.01.2020**
(21) Anmeldenummer: 15188328.7
(22) Anmeldetag: 05.10.2015
(51) Int. Cl.: H01L 23/495

(54) **SCHALTUNGSANORDNUNG UND LEISTUNGSMODUL**
CIRCUIT ASSEMBLY AND POWER MODULE
SYSTEME DE COMMUTATION ET MODULE DE PUISSANCE

(30) Priorität: 21.10.2014 DE 102014221296
(43) Veröffentlichungstag der Anmeldung: 27.04.2016
(73) Patentinhaber: ROBERT BOSCH GMBH, 70442 Stuttgart (DE)
(72) Erfinder: Sueske, Erik, 72764 Reutlingen (DE); Orso, Steffen, 72764 Reutlingen (DE); Baer, Alexander, 72760 Reutlingen (DE)

(56) Entgegenhaltungen:
- WO-A1-2014/038066

## Beschreibung

Die Erfindung betrifft eine Schaltungsanordnung und ein die Schaltungsanordnung umfassendes Leistungsmodul gemäß den Oberbegriffen der unabhängigen Ansprüche.

### Stand der Technik

Eine bekannte Schaltungsanordnung ist in der internationalen Patentanmeldung WO2014/038066 beschrieben (auf Englisch veröffentlicht als EP 2 894 952). Heutige Schaltungsanordnungen weisen eine Vielzahl von unterschiedlichen Aufbaumöglichkeiten auf. Zum einen stehen verschiedene Substrattechnologien zu Verfügung. Ein Substrat dient als Träger einer Schaltung. Oft eingesetzte Substrate sind beispielsweise ein Direct-Bonded Copper-Substrat (DBC), Insulated Metals Substrat (IMS) oder Leiterplatten, sogenannte Printed Circuit Boards (PCB). Ebenso bekannt sind Stanzgitter, beispielsweise aus Kupfer. Diese können nach einem Bestücken mit elektrischen und/oder elektronischen Bauelementen mit einer Moldmasse umspritzt werden. Derartige Schaltungslösungen sind unter dem Begriff "Multi Chip Power Package" (MCPP) allgemein bekannt. Die Auswahl der Substrattechnologie richtet sich unter anderem nach der möglichen Aufbau- und Verbindungstechnik für die Schaltung. Ebenso spielen unter anderem Vorgaben für eine Entwärmung der Schaltung, Platzverhältnisse und Fertigungskosten für eine umzusetzende Schaltung eine Rolle.

Ferner werden beim Aufbau von elektronischen Schaltungen eine Vielzahl von elektrischen und/oder elektronischen Bauelementen auf einem Schaltungsträger angeordnet. Oft eingesetzt werden sogenannte SMD-Bauelemente (surfacemounted-Device). Diese weisen Anschlussbereiche auf, welche direkt mit der Oberfläche eines Schaltungsträgers verbunden werden können, beispielsweise durch ein Verlöten mit einer auf dem Schaltungsträger ausgebildeten Leiterstruktur und/oder einer elektrischen Kontaktstelle. Als SMD-Bauelemente können beispielsweise Kondensatoren, beispielsweise MLCCs (Multi-Layer Ceramic Capacitor), ausgebildet sein. Ebenso bekannt sind Widerstände, wie zum Beispiel NTCs (Negative Temperature Coefficient Thermostors).

Schaltungsanordnungen sind bei deren Herstellung und/oder im Betrieb der Schaltung verschiedenartigen Belastungen ausgesetzt. Oft treten dabei mechanische Belastungen auf. In vielen Fällen werden diese mechanischen Belastungen an einzelnen Stellen des Schaltungsträgers eingeleitet, beispielsweise in Form von Zug-, Druck- und/oder Biegespannungen. Dies kann beispielsweise während eines Herstellprozesses der Schaltung erfolgen. Durch Auflegen eines elektrischen und/oder elektronischen Bauelementes auf den Schaltungsträger, beispielsweise mittels eines Bestückungsautomaten, oder dem anschließenden elektrischen Verbinden mit dem Schaltungsträger können mechanische Kräfte auf den Schaltungsträger einwirken. Insbesondere kann der Schaltungsträger aufgrund der Krafteinwirkung abschnittsweise oder im Gesamten durchgebogen werden. Ebenso ist es möglich, dass derartige mechanische Belastungen auch im Zuge von Temperatureinwirkungen, insbesondere durch ein temperaturbehaftetes elektrisches Verbinden eines elektrischen und/oder elektronischen Bauelementes mit dem Schaltungsträger, auftreten. Dabei ist es sehr problematisch, dass derartige mechanische Belastungen über den Schaltungsträger auch auf die mit dem Schaltungsträger verbundenen elektrischen und/oder elektronischen Bauelemente und deren Verbindungsstelle mit dem Schaltungsträger übertragen werden. In vielen Fällen kommt es dabei bereits bei der Fertigung und/oder im Betrieb der Schaltungen zu einem mechanischen Bruch am elektrischen und/oder elektronischen Bauelement und/oder an dessen Verbindungsstellen mit dem Schaltungsträger. Als Folge eines derartigen mechanischen Bruchs ist die Schaltung zumindest gestört, im schlimmsten Falle nicht mehr betriebsfähig.

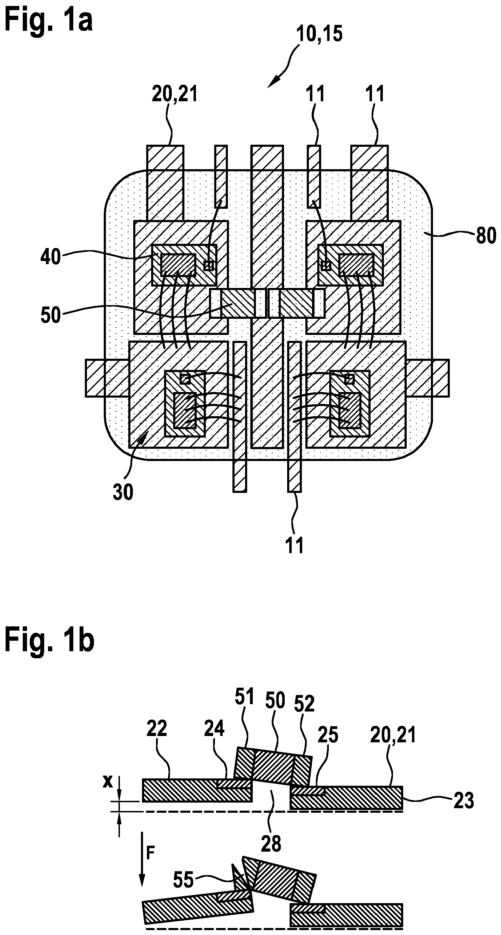

Die Fig. 1a und 1b veranschaulichen die Problematik an einem beispielhaften Leistungsmodul 10. Das Leistungsmodul 10 umfasst eine Schaltungsanordnung 15. Die Schaltungsanordnung 15 weist mindestens einen Schaltungsträger 20 auf. Der Schaltungsträger 20 ist in Form eines Kupferstanzgitters ausgebildet. Das Kupferstanzgitter 20 ist derart ausgebildet, dass es zumindest eine Leiterstruktur 21 umfasst. Auf dem Kupferstanzgitter 20 ist eine Schaltung 30 angeordnet. Die Schaltung 30 und zumindest ein Teil des Kupferstanzgitters 20 ist von einer Moldmasse 80 umspritzt. Seitlich der Moldmasse 80 stehen Anschlussbeinchen 11 heraus, mittels welchen das Leistungsmodul 10 in beispielsweise einem elektrischen Gerät elektrisch eingebunden werden kann. Die Schaltung 30 umfasst elektrische und/oder elektronische Bauelemente, beispielsweise einen Leistungshalbleiter 40, insbesondere ein MOSFET, und ein SMD-Bauelement, beispielsweise ein SMD-Kondensator 50, insbesondere ein MLCC. Fig. 1b zeigt in einer Seitendarstellung ausschnittsweise den Bereich der Schaltungsanordnung 15, in welchem ein SMD-Kondensator 50 mit der Leiterstruktur 21 elektrisch verbunden ist. Dargestellt sind zwei benachbarte Bereiche 22, 23 des Kupferstanzgitters 20. Beide benachbarten Bereiche 22,23 des Kupferstanzgitters 20 sind Teil der Leiterstruktur 21. Der eine benachbarte Bereich 22 weist eine erste Kontaktstelle 24 und der andere benachbarte Bereich 23 eine zweite Kontaktstelle 25 auf. Zwischen der ersten und der zweiten Kontaktstelle 24, 25 weist das Kupferstanzgitter 20 eine Aussparung in Form eines Spaltes 28 zwischen den zwei benachbarten Bereichen 22, 23 auf. Die erste Kontaktstelle 24 ist mit einem ersten Anschlussbereich 51 des SMD-Kondensators 50 elektrisch verbunden und die zweite Kontaktstelle 25 ist mit einem zweiten Anschlussbereich 52 des SMD-Kondensators 50 elektrisch verbunden. In der Darstellung von Fig. 1b ist zu sehen, dass der so elektrisch verbundene SMD-Kondensator 50 den Spalt 28 zwischen den benachbarten Bereichen 22, 23 des Kupferstanzgitters 20 überbrückt. Die zwei benachbarten Bereiche 22, 23 können bei der Herstellung und/oder im späteren Betrieb der Schaltung 30 relativ zueinander bewegt werden, insbesondere unter Ausbildung eines Versatzes x zueinander. Durch den Versatz x werden mechanische Spannungen von dem Kupferstanzgitter 20 in die Verbindungsstellen 24, 25, 51, 52 des SMD-Kondensators 50 mit dem Kupferstanzgitter 20 eingeleitet. In vielen Fällen führt dies zu einem Bruch 55 des SMD-Kondensators 50 und/oder einer Fehlstelle an den Kontaktstellen 24, 25 bzw. den Anschlussbereichen 51, 52 des SMD-Kondensators 50. Insbesondere können in solchen Fällen dann Kurzschlüsse zwischen den Elektroden des SMD-Kondensators 50 auftreten. Die Bruchgefahr wird weiter erhöht, je kompakter die elektrischen und/oder elektronischen Bauelemente 40, 50 auf dem Schaltungsträger 20 angeordnet werden. Sich ergebende mechanische Spannungen können an keiner Stelle vorher aufgenommen oder abgebaut werden, bevor sie letztendlich direkt auch auf die elektrischen und/oder elektronischen Bauelemente 40, 50 einwirken.

Gerade bei Leistungsmodulen mit hohen Schaltfrequenzen, bei welchen beispielsweise Leistungshalbleiter mit SiC- Technologie vorgesehen werden, ist es besonders erforderlich, zur Minimierung parasitärer Induktivitäten einen Kondensator, beispielsweise einen MLCC-Kondensator, in unmittelbarer Nähe zum Leistungshalbleiter anzuordnen.

Zum Schutz elektrischer und/oder elektronischer Bauelemente vor einer Überlastung, insbesondere einem Bruch infolge von auf sie einwirkenden mechanischen Belastungen ist es bekannt, elastische Zonen in unmittelbarer Nähe zu den zu beschützenden elektrischen und/oder elektronischen Bauelementen vorzusehen. In den elastischen Zonen werden die in der Schaltungsanordnung vorliegenden mechanischen Spannungen durch ein Nachgeben der elastischen Zonen wieder abgebaut. Dies erfolgt in einer Weise noch bevor mögliche mechanische Spannungen einen Schaden an den elektrischen und/oder elektronischen Bauelementen verursachen können. So sind elastische Zonen beispielsweise als Aussparungen im Schaltungsträger ausgebildet. Die Aussparungen können verschiedenste Muster und Ausführungen darstellen. Oft sind diese Aussparungen vor und/oder hinter oder um ein elektrisches und/oder elektronisches Bauelement im Schaltungsträger ausgebildet. Grundsätzlich ist eine Anordnung in der Art vorgesehen, dass eine Nachgiebigkeit des Schaltungsträgers im Bereich der Aussparungen in Richtung einer mechanischen Belastung erfolgen kann. Derartige Aussparungen müssen zusätzlich in einen Schaltungsträger eingebracht werden. Außerdem nehmen derartige Aussparungen Platz auf dem Schaltungsträger ein, der einer kompakten Anordnung von elektrischen und/oder elektronischen Bauelementen zuwiderläuft.

### Offenbarung der Erfindung

### Vorteile

Der Erfindung liegt die Aufgabe zu Grunde, eine Schaltungsanordnung anzugeben, bei welche eine kompakte Anordnung von elektrischen und/oder elektronischen Bauelementen ermöglicht wird. Ferner ist es Aufgabe, dass die elektrischen und/oder elektronischen Bauelemente und/oder ihre Verbindungsstellen mit einem Schaltungsträger bei der Herstellung der Schaltungsanordnung vor der Einwirkung mechanischer und/oder thermomechanischen Belastungen geschützt sind. Eine derartige Schutzwirkung soll auch im Betrieb der von der Schaltungsanordnung gebildeten Schaltung erhalten bleiben. Des Weiteren ist es Aufgabe, ein Leistungsmodul enthaltend eine derartige Schaltungsanordnung mit zumindest einem Leistungshalbleiter anzugeben.

Diese Aufgabe wird durch eine Schaltungsanordnung und durch ein Leistungsmodul mit den kennzeichnenden Merkmalen der unabhängigen Ansprüche gelöst.

Die erfindungsgemäße Schaltungsanordnung umfasst zumindest einen Schaltungsträger mit zumindest einer auf dem Schaltungsträger ausgebildeten Leiterstruktur. Die Leiterstruktur weist zumindest eine erste und eine zweite elektrische Kontaktstelle auf. Zusätzlich umfasst die erfindungsgemäße Schaltungsanordnung zumindest ein elektrisches und/oder elektronisches Bauelement mit zumindest einem ersten und einem zweiten Anschlussbereich. Zur Ausbildung einer Schaltung ist die zumindest erste Kontaktstelle der Leiterstruktur mit dem zumindest ersten elektrischen Anschlussbereich des elektrischen und/oder elektronischen Bauelements und/oder ist die zumindest zweite Kontaktstelle der Leiterstruktur mit dem zumindest zweiten Anschlussbereich des elektrischen und/oder elektronischen Bauelements mittelbar oder unmittelbar elektrisch verbunden.

Kennzeichnend für die Erfindung ist, dass das zumindest eine elektrische und/oder elektronische Bauelement zur Reduzierung einer Übertragung mechanischer Belastungen von dem zumindest einen Schaltungsträger auf zumindest einem Trägerelement angeordnet ist. Dabei ist das zumindest eine elektrische und/oder elektronische Bauelement über das zumindest eine Trägerelement mittelbar mit dem zumindest einen Schaltungsträger verbunden. Dies erfolgt dadurch, dass das zumindest eine Trägerelement mit dem zumindest einen Schaltungsträger verbunden ist. Das Trägerelement ist in vorteilhafter Weise mit dem Schaltungsträger derart verbunden, dass zumindest ein Teil einer auf den Schaltungsträger einwirkenden mechanischen Belastung zuerst auf das zumindest eine Trägerelement übertragen wird, bevor es dann auch auf das zumindest eine elektrische und/oder elektronische Bauelement einwirken kann. Bevorzugt wird die vollständige mechanische Belastung durch das zumindest eine Trägerelement aufgenommen, zumindest jedoch in einem solchen Maße, dass eine verbleibende auf das eine elektrische und/oder elektronische Bauelement einwirkende mechanische Belastung keinen Schaden an diesem oder an den Verbindungsstellen mit dem Schaltungsträger hervorrufen kann. Daher weist das Trägerelement eine größere Zug- , Druck- und/oder Biegefestigkeit auf als das zumindest eine elektrische und/oder elektronische Bauelement, welches auf dem zumindest einen Trägerelement angeordnet ist. In 3-Punkt-Biegeversuchen an einer erfindungsgemäßen Schaltungsanordnung kann gezeigt werden, dass ein Bruch des einen elektrischen und/oder elektronischen Bauelementes erst bei einer bis zu 5-fachen Belastung erfolgt, als bei einer vergleichbaren Schaltungsanordnung, bei welcher das elektrische und/oder elektronische Bauelement ohne einem erfindungsgemäß vorgesehenen Trägerelement direkt auf einem Schaltungsträger angeordnet ist. Solange daher das zumindest eine Trägerelement den mechanischen Belastungen standhalten kann, solange ist auch das zumindest eine elektrische und/oder elektronische Bauelement vor diesen geschützt. Insbesondere gilt eine derartige Schutzwirkung für SMD-Bauelemente, wie beispielsweise ein NTC oder ein MLCC. In vorteilhafter Weise können dadurch sehr kompakte und kostengünstige Schaltungen auf Schaltungsträgern realisiert werden. Insbesondere ist die Fehlerquote in der Herstellung von Schaltungsanordnungen umfassend SMD-Bauelemente in vorteilhafter Weise stark reduziert. Zusätzlich ist die Betriebssicherheit derartiger Schaltungsanordnungen erhöht.

Erfindungsgemäß kommen verschiedenste Ausführungen von Schaltungsträgern zum Tragen. So können beispielsweise DBCs, IMSs, PCBs und sogar Stanzgitter, insbesondere aus Kupfer, vorgesehen werden, ohne von einer erfindungsgemäß beabsichtigten Schutzwirkung des Trägerelementes in Verbindung mit dem Schaltungsträger abzuweichen. In vorteilhafter Weise können somit Schaltungsanordnungen für eine Vielzahl individueller Anforderungen ausgelegt und hergestellt werden.

Bevorzugt ist das zumindest eine Trägerelement aus einem keramischen Material gebildet, beispielsweise aus Si3N4, AIN, ZTA (Zirconia Toughened Alumina, AL2O3 + Zro2), SiO2, B2O3, PBO, Na2O, K2O, Li2O, CaO, MgO, ZnO und/oder aus Al2O3. In vorteilhafter Weise kann das keramische Material Teil eines DBC- (Direct copper bonded), LTCC- (Low Temperature Cofired Ceramics), eines AMB- (Active Metal Brazing) oder eines IMS-(Insulated Metal Substrate)Substrates sein. Dadurch kann man sehr kostengünstige Trägerelemente aus bekannten, in großen Stückzahlen vorliegenden Ausgangssubstraten für Schaltungsträger erhalten. Die Keramik kann besonders hohe Zugkräfte aufnehmen.

Alternativ kann das zumindest eine Trägerelement aus einem organischen Material gebildet sein, insbesondere aus einem Polymermaterial, bevorzugt aus einem Faser-Kunststoff-Verbund. Als Polymermaterial kommen weiter zum einen bevorzugt thermoplastische Kunststoffe zum Einsatz, beispielsweise Polyetheretherketon (PEEK), Polyphenylensulfid (PPS), Polysulfon (PSU), Polyetherimid (PEI) oder Polytetrafluorethen (PTFE). Zum anderen können auch duroplastische Kunststoffe vorgesehen werden, beispielsweise ein Epoxidharz (EP), ungesättigtes Polyesterharz (UP), Vinylesterharz (VE), Phenol-Formaldehydharz (PF), Diallylphthalatharz (DAP), Methacrylatharz (MMA), Polyurethan (PUR), Aminoharze wie Melaminharz (MF/MP) oder Harnstoffharz (UF), Polyimide (PI). Die thermoplastischen und duroplastischen Kunststoff sind bevorzugt elektrisch nicht leitend. Dabei können sie auch eine Kunststoffmatrix eines Faser-Kunststoff-Verbundes bilden, wobei in der Kunststoffmatrix insbesondere anorganische oder organische Verstärkungsfasern eingebracht sind. Insbesondere ist vorteilhaft, wenn eine Ausführung vorgesehen ist, welche hohen mechanischen Belastungen standhält. In vorteilhafter Weise kann das Trägermaterial auch aus einem PCB oder aus einem plattenartigen Halbzeug eines Faser-Kunststoff-Verbundes ausgebildet sein, um ein sehr kostengünstiges Trägerelement zu erhalten.

Sowohl das genannte Trägerelement aus dem keramischen Material als auch das genannte Trägerelement aus dem organischen Material bilden daher bevorzugt eine elektrische Isolation zwischen dem zumindest einen elektrischen und/oder elektronischen Bauelement und dem zumindest einen Schaltungsträger aus. Neben einem keramischen Material oder einem organischen Material sind auch Trägerelemente aus einem anderen Material denkbar, wobei dann zumindest eine Ausführung vorliegt, mittels welcher eine oben genannte elektrische Isolation ausgebildet ist.

In Weiterbildung der erfindungsgemäßen Schaltungsanordnung ist das zumindest eine Trägerelement plattenartig ausgebildet. In dieser Ausführung ist das zumindest eine elektrische und/oder elektronische Bauelement auf einer Oberseite des Trägerelementes angeordnet. Dagegen ist eine Unterseite des Trägerelementes zumindest bereichsweise mit dem zumindest einen Schaltungsträger verbunden. Auf dieser Weise weist das Trägerelement beidseitig zwei ebene Flächen auf. Zum einen kann somit das Trägerelement ganzflächig mit dem Schaltungsträger verbunden werden. Dadurch ist garantiert, dass mechanische Belastungen von dem gesamten Trägerelement aufgenommen werden kann. Ferner ist eine einfache Anordnung des zumindest einen elektrischen und/oder elektronischen Bauelements auf dem Trägerelement, insbesondere auf dessen Oberseite, ermöglicht. Ein plattenartig ausgebildetes Trägerelement ergibt sich beispielsweise in einfacher Weise aus einem der oben genannten Ausgangssubstraten wie z.B. aus einem DBC, LTCC, AMB, IMS oder einem PBC. Ebenso können plattenartige Halbzeuge aus einem Faser-Kunststoff-Verbund zur Ausbildung eines erfindungsgemäßen Trägerelements vorgesehen werden. Das Trägerelement weist bevorzugt eine Dicke von 50µm bis 5 mm auf.

Die erfindungsgemäße Schaltungsanordnung berücksichtigt auch einen Schaltungsträger, welcher zwischen der ersten und der zweiten Kontaktstelle der Leiterstruktur eine Aussparung, insbesondere in Form eines Durchbruches, aufweist. Hierbei ist die Aussparung in zumindest einem Bereich durch das zumindest eine Trägerelement überbrückt. Dabei kann die Aussparung beispielsweise eine Längserstreckung aufweisen, insbesondere aufgrund einer rechteckigen Grundform. Eine derartige Aussparung ist beispielsweise als ein Spalt zwischen zwei benachbarten Bereichen eines Stanzgitters ausgebildet, wobei die zwei benachbarten Bereiche dann jeweils die zumindest erste bzw. die zweite Kontaktstelle aufweisen. Im Bereich der Aussparung kann es zu Relativbewegungen innerhalb des Schaltungsträgers kommen, beispielsweise bei der Fertigung der Schaltungsanordnung und/oder im Betrieb der durch die Schaltungsanordnung gebildeten Schaltung aufgrund von Temperaturwechsel. Insbesondere gilt dies bei benachbarten Bereichen eines Stanzgitters. Die hierbei entstehenden mechanischen Belastungen werden allerdings in vorteilhafter Weise durch das die Aussparung überbrückende Trägerelement aufgenommen. Idealerweise wirken dann keine oder nur in einem reduzierten Maße mechanische Belastungen auf das zumindest eine elektrische und/oder elektronische Bauelement, welches auf dem Trägerelement angeordnet ist. Dies gilt dann für beliebige Anordnungen des zumindest einen elektrischen und/oder elektronischen Bauelementes. Bevorzugt ist das zumindest eine elektrische und/oder elektronische Bauelement in Richtung der Längserstreckung der Aussparung oder quer zu dieser auf dem zumindest einen Trägerelement angeordnet. Zuvor genanntes gilt auch für eine Ausführungen, bei welcher die Aussparung durch mindestens zwei, bevorzugt parallel zueinander angeordneten, Trägerelemente überbrückt ist. Hierbei kann auf jedem Trägerelement einzeln jeweils ein elektrisches und/oder elektronisches Bauelement angeordnet sein. Zusätzlich ist hier auch möglich, dass das zumindest eine elektrische und/oder elektronische Bauelement auf dem ersten und auf dem zweiten Trägerelement angeordnet ist. In diesem Falle kann ein zwischen den zwei Trägerelementen vorliegender Spalt aufgrund einer Beabstandung der Trägerelemente zueinander durch das zumindest eine elektrische und/oder elektronische Bauelement überbrückt sein.

In Weiterführung der erfindungsgemäßen Schaltungsanordnung ist vorgesehen, dass das zumindest eine Trägerelement mittels einer Kleberschicht mit dem zumindest einen Schaltungsträger verbunden ist. Ebenso kann das zumindest eine elektrische und/oder elektronische Bauelement mittels einer Kleberschicht mit dem Trägerelement verbunden sein. Alternativ ist eine Verbindung des Trägerelementes mit dem Schaltungsträger und/oder eine Verbindung des einen elektrischen und/oder elektronischen Bauelements mit dem Schaltungsträger mittels einer Lot- oder einer Sinterschicht denkbar. Hierzu weist das Trägerelement jeweils zumindest einen Oberflächenbereich auf, welcher ein Verlöten und/oder Versintern mit dem Schaltungsträger bzw. mit dem einen elektrischen und/oder elektronischen Bauelement ermöglicht, beispielsweise durch eine metallische Schicht. Im Falle einer plattenartigen Ausbildung des Trägerelementes kann ein derartiger Oberflächenbereich auf der Unterseite und/oder der Oberseite des Trägerelementes ausgebildet sein. Sowohl das Verkleben als auch das Verlöten und/oder Versintern des Trägerelementes mit dem Schaltungsträger bzw. dem zumindest einen elektrischen und/oder elektronischen Bauelement kann dann über die komplette Unterseite bzw. Oberseite oder einen Teilbereich der Unterseite bzw. der Oberseite des Trägerelementes erfolgen.

Erfindungsgemäß ist vorgesehen, dass die zumindest erste und/oder die zweite Kontaktstelle der Leiterstruktur und/oder der zumindest erste und/oder zweite Anschlussbereich des zumindest einen elektrischen und/oder elektronischen Bauelementes mittels eines gebondenen Drahtes oder Bändchens, eines gelöteten Clips und/oder einer Durchkontaktierung elektrisch kontaktiert ist/sind, wobei die Durchkontaktierung in dem zumindest einen Trägerelement ausgebildet ist.

Bevorzugt weist das Trägerelement selbst zumindest einen Oberflächenbereich auf, welcher eine Kontaktierung insbesondere mittels einer Bändchen- bzw. Drahtbondtechnik , einer Cliplötung und/oder einer Versinterung ermöglicht. In diesem Fall erfolgt eine mittelbare Verbindung zwischen der ersten bzw. zweiten Kontaktstelle der Leiterstruktur und dem ersten bzw. zweiten Anschlussbereich des zumindest einen elektrischen und/oder elektronischen Bauelementes über den oben genannten Oberflächenbereich auf dem Trägerelement. Konkret ist der zumindest eine Oberflächenbereich des Trägerelementes zum einen mit dem ersten und/oder dem zweiten Anschlussbereich des zumindest einen elektrischen und/oder elektronischen Bauelementes elektrisch kontaktiert, beispielsweise durch Verlöten und/oder Versintern, insbesondere mittels eines Draht- oder Bändchenbonds oder eines Lötclips. Zum anderen ist der zumindest eine Oberflächenbereich des Trägerelementes auch mit der ersten und/oder mit der zweiten Kontaktstelle der Leiterstruktur mittels einer Drahtbondtechnik, einer Cliplötung und/oder einer Durchkontaktierung verbunden, wobei die Durchkontaktierung in dem zumindest einen Trägerelement ausgebildet ist.

Insgesamt sind daher eine Vielzahl von Verbindungsmöglichkeiten zwischen Trägerelement und/oder dem zumindest einen elektrischen und/oder elektronischen Bauelement und/oder dem Schaltungsträger und/oder der ersten und/oder der zweiten Kontaktstelle der Leiterstruktur und/oder der ersten und/oder dem zweiten Anschlussbereich des zumindest einen elektrischen und/oder elektronischen Bauelementes gegeben.

Die Erfindung betrifft auch ein Leistungsmodul, beispielsweiser einen Inverter. Die Erfindung geht aus von einem Leistungsmodul wie in den Fig. 1a und 1b dargestellt. Neben zumindest einem Leistungshalbleiter umfasst das erfindungsgemäße Leistungsmodul allerdings die zuvor beschriebenen Ausführungen einer erfindungsgemäßen Schaltungsanordnung. Bevorzugt basiert der Leistungshalbleiter auf einer SiC-Technologie. Derartige Leistungshalbleiter weisen hohe Schaltfrequenzen auf. Zur Minimierung der dabei vorliegenden parasitären Induktivitäten ist ein SMD-Kondensator, insbesondere ein MLCC-Kondensator, vorgesehen. Erfindungsgemäß ist nun ermöglicht, das Leistungsmodul derart auszubilden, dass der SMD-Kondensator in unmittelbarer Nähe zum Leistungshalbleiter angeordnet ist.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
Fig. 1a: ein Leistungsmodul umfassend einen Leistungshalbleiter in der Draufsicht,
Fig. 1b: einen Ausschnitt des Leistungsmodules in Fig. 1a in einer Seitendarstellung,
Fig. 2.1 - 2.15 verschiedene Ausführungsbeispiele einer erfindungsgemäßen Schaltungsanordnung jeweils in einer Seitenansicht und einer zugehörigen Draufsicht.

### Ausführungsformen der Erfindung

In den Figuren sind funktional gleiche Bauteile jeweils mit gleichen Bezugszeichen gekennzeichnet.

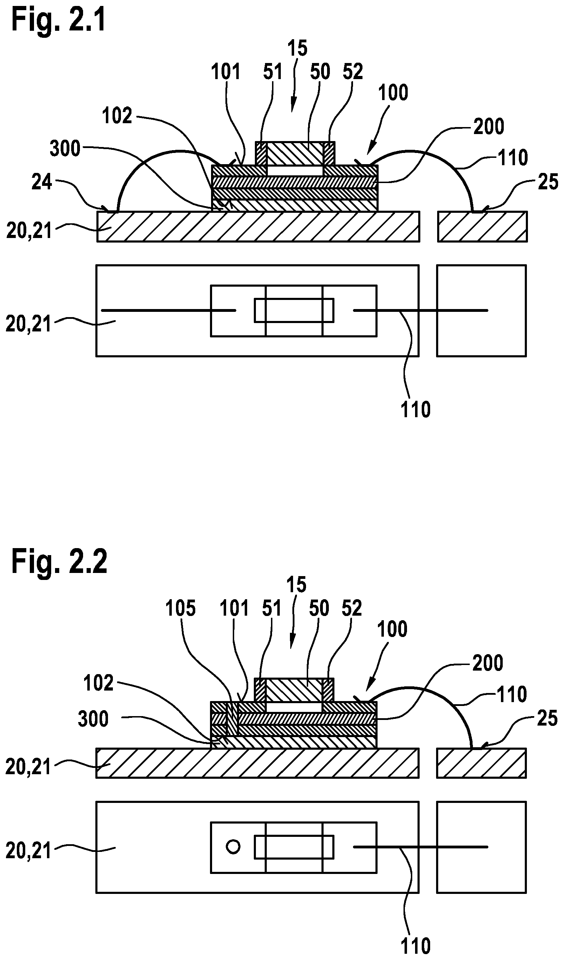

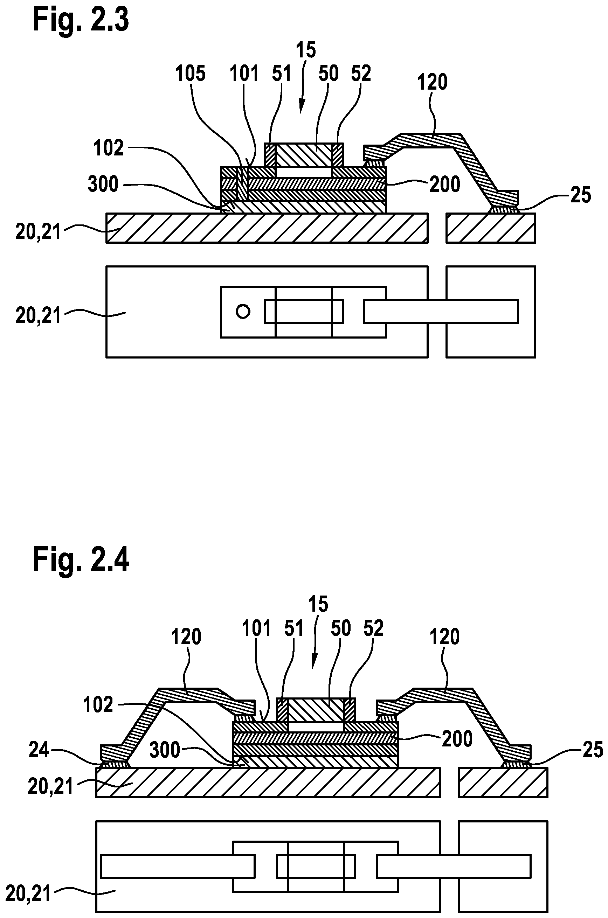

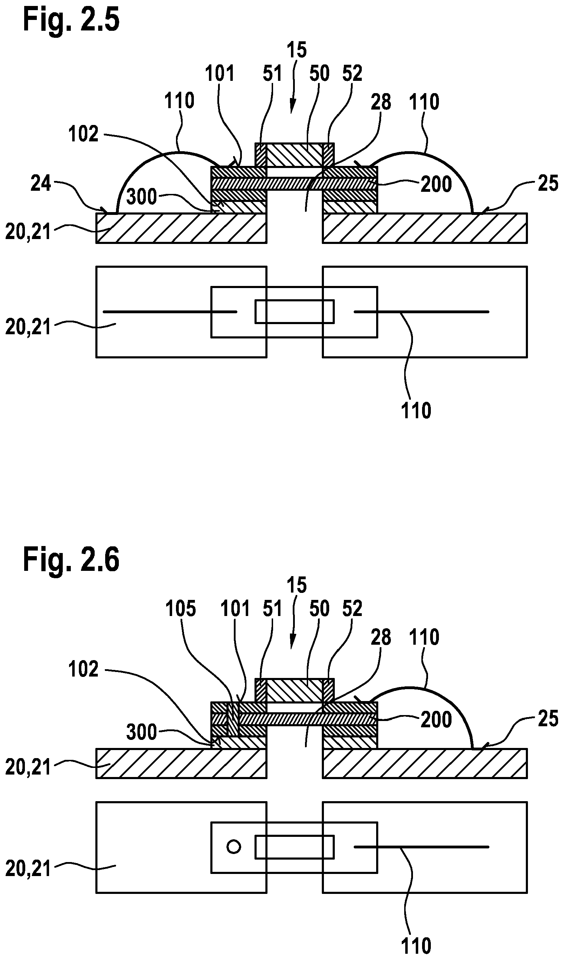

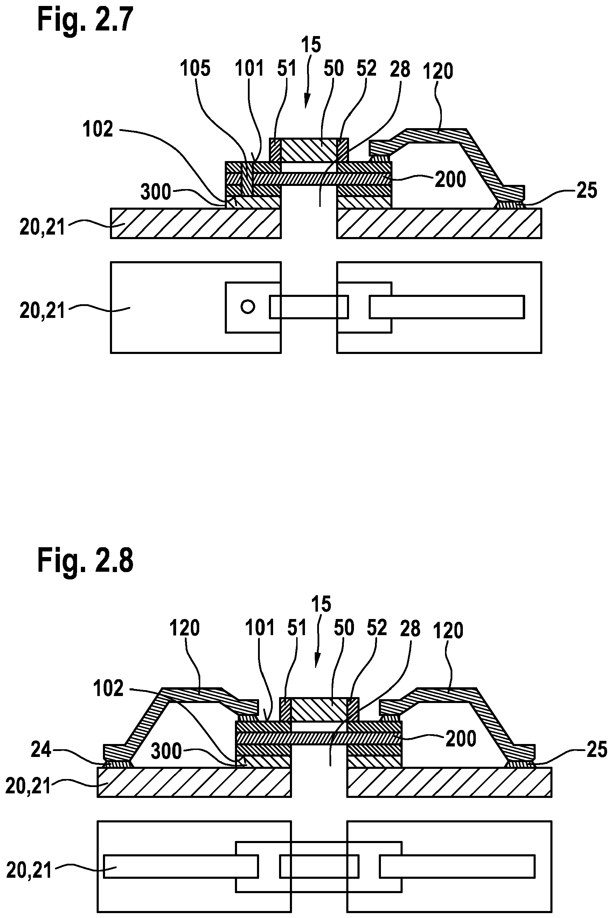

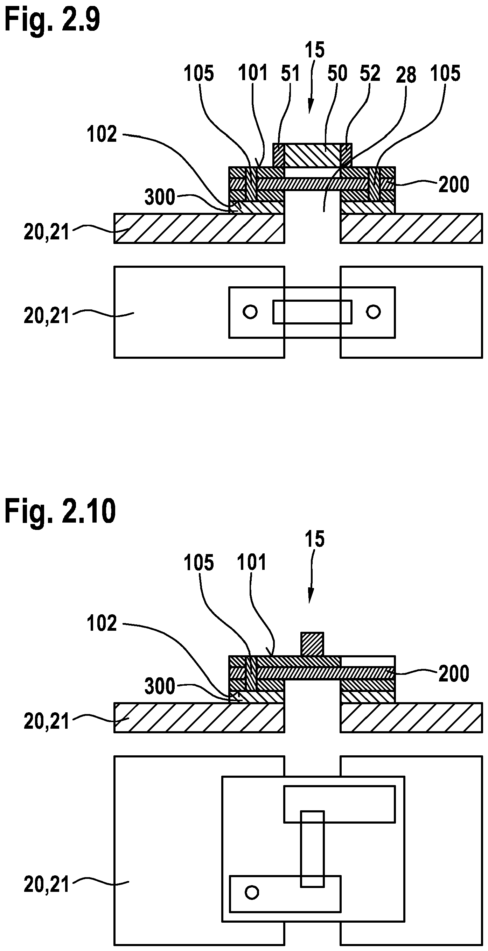

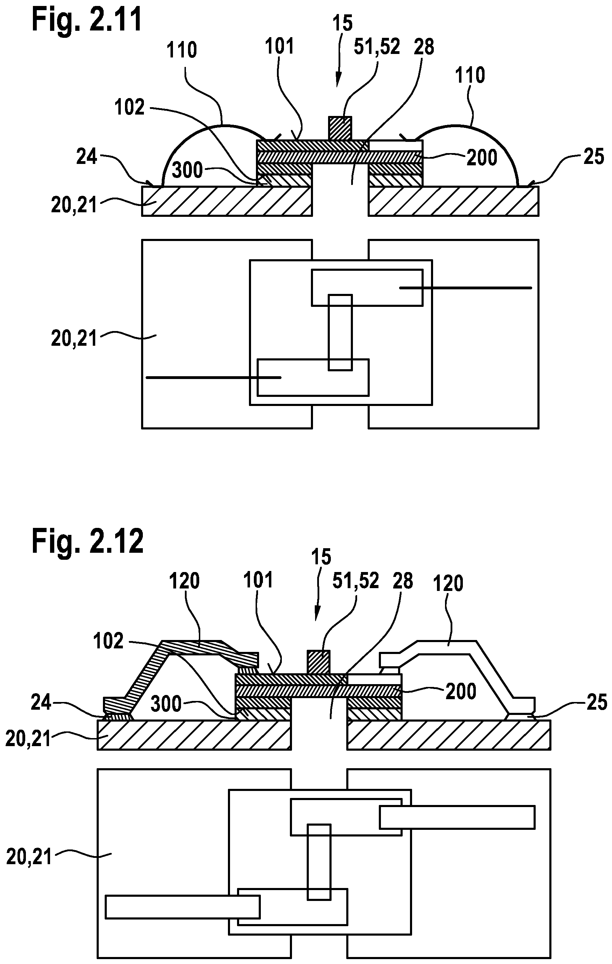

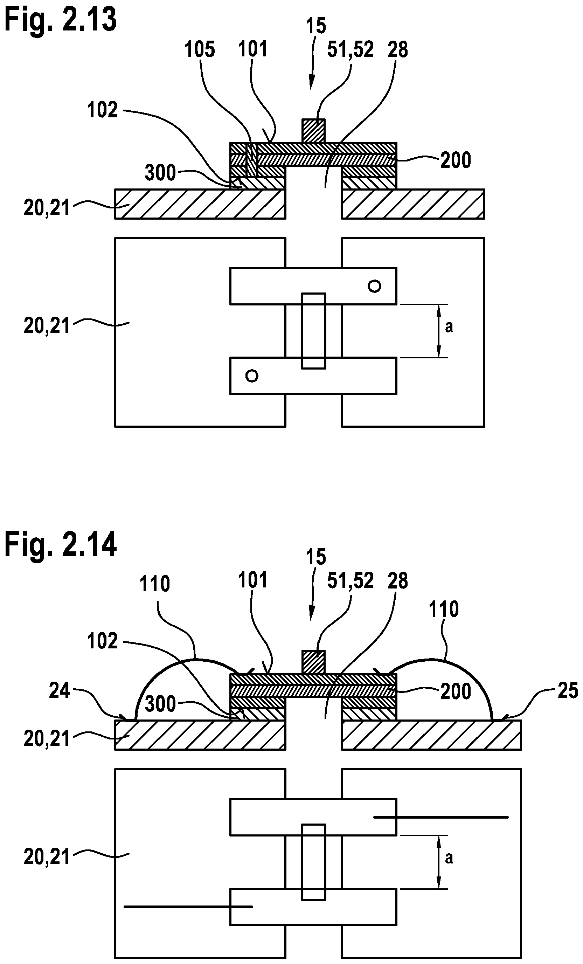

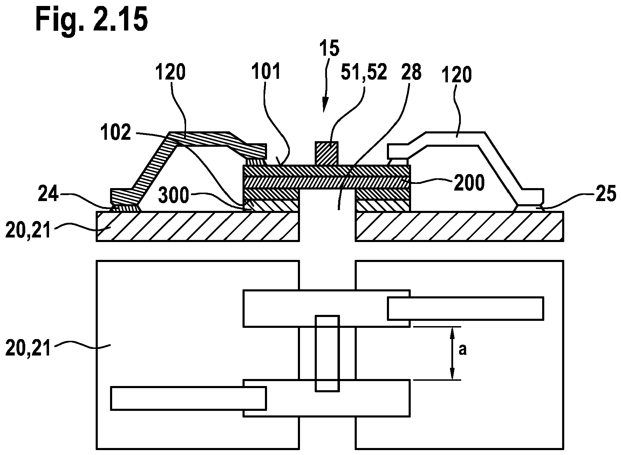

Alle Ausführungsbeispiele in den Fig. 2.1 - 2.15 zeigen einen Schaltungsträger 20 mit einer auf dem Schaltungsträger 20 ausgebildeten Leiterstruktur 21. Die Leiterstruktur 21 kann eine Mehrzahl von Leiterbahnen umfassen, welche beispielsweise Teil eines als Leiterplatte ausgebildeten Schaltungsträgers 20 sind. Es sind alternativ auch andere Typen von Schaltungsträger denkbar. Mit dem Schaltungsträger 20 ist zumindest ein Trägerelement 100 verbunden. Das Trägerelement 100 ist plattenartig ausgebildet und weist eine Oberseite 101 und eine Unterseite 102 auf. Sowohl die Oberseite 101 als auch die Unterseite 102 umfassen jeweils zumindest einen Oberflächenbereich, welcher jeweils durch Löten und/oder Sintern und/oder mittels eines Draht- oder Bänchenbond elektrisch kontaktierbar ist. Das Trägerelement 100 ist über seine Unterseite 102 flächig mit dem Schaltungsträger 20 verbunden, beispielsweise mittels einer Lotschicht 300. Anstelle der Lotschicht 300 ist auch eine Sinterschicht oder eine Kleberschicht denkbar. Alternativ kann die Lotschicht 300 oder die Sinterschicht oder die Kleberschicht die Unterseite 102 des Trägerelementes 100 auch nur in Teilbereichen, beispielsweise in den Randbereichen, mit dem Schaltungsträger 20 verbinden. Auf der Oberseite 101 des Trägerelementes 100 ist ein elektrisches und/oder elektronisches Bauelement 50 angeordnet, insbesondere ein SMD-Bauteil, beispielsweise ein MLCC-Kondensator. Das elektrische und/oder elektronische Bauelement 50 weist an seinen Enden einen ersten und einen zweiten Anschlussbereich 51, 52 auf. Über den ersten und den zweiten Anschlussbereich 51, 52 ist das elektrische und/oder elektronische Bauelement 50 mit der Oberseite 101 des Trägerelementes 100 verbunden, insbesondere durch ein Verlöten oder Versintern. Hierzu weist die Oberseite 101 des Trägerelementes 100 randseitig einen ersten und zweiten Oberflächenbereich auf, welcher durch Löten und/oder Sintern elektrisch kontaktierbar ist, wobei ein elektrisches Kontaktieren auch mittels einer Draht-/Bändchenbondtechnik oder einer Cliplötung/-sinterung möglich ist. Das Trägerelement 100 ist in diesem Ausführungsbeispiel aus einem DBC-Substrat gebildet und weist in seinem Inneren einen keramischen Kern 200 auf. Die Oberseite 101 und die Unterseite 102 sind in diesem Fall aus Kupfer gebildet. In den Ausführungsbeispielen entsprechend den Fig. 2.5 - 2.15 ist im Schaltungsträger 20 eine Aussparung 28 in Form eines Durchbruchs ausgebildet. Beispielsweise kann dieser Durchbruch als Spalt zwischen zwei benachbarten Bereichen eines Kupferstanzgitters als Schaltungsträger 20 vorliegen. Die Aussparung 28 weist eine Längserstreckung auf, wobei das Trägerelement 100 quer zur Längserstreckung angeordnet ist und die Aussparung 28 in einem Bereich von dem Trägerelement 100 überbrückt ist. Bei diesen Ausführungsbeispielen mit einer im Schaltungsträger 20 ausgebildeten Aussparung 28 kann das elektrische und/oder elektronische Bauelement 50 auf dem Trägerelement 100 und quer zur Längserstreckung der Aussparung 28 angeordnet sein, entsprechend den Darstellungen in den Fig. 2.5 - 2.9. Ebenso ist eine Anordnung entsprechend den Darstellungen in den Fig. 2.10 - 2.15 möglich. Bei diesen Ausführungsbeispielen ist das elektrische und elektronische Bauelement 50 auf dem Trägerelement 100 und in Richtung der Längserstreckung der im Schaltungsträger 20 ausgebildeten Aussparung 28 angeordnet. Für diesen Fall ist entsprechend den Darstellungen in den Fig. 2.10 - 2.12 das Trägerelement 100 in Richtung der Längserstreckung breiter ausgeführt als die entsprechende Ausführung des Trägerelementes 100 in den Fig. 2.1 - 2.9. Alternativ sind auch zwei Trägerelemente 100 vorgesehen, die bevorzugt parallel zueinander in einem Abstand a angeordnet sind. In diesem Fall ist das elektrische und/oder elektronische Bauelement 50 auf dem ersten und auf dem zweiten Trägerelement 100 angeordnet, wobei der Abstand a zwischen den beiden Trägerelementen 100 durch das elektrische und/oder elektronische Bauelement 50 überbrückt ist.

In allen Ausführungsbeispielen ist eine erste bzw. eine zweite Kontaktstelle 24, 25 der Leiterstruktur 21 mittelbar über die Oberseite 101 mit dem ersten Anschlussbereich bzw. dem zweiten Anschlussbereich 51, 52 des elektrischen und/oder elektronischen Bauelementes 50 verbunden. Die jeweilige elektrische Verbindung ist dabei hergestellt durch einen Bonddraht bzw. -bändchen 110 oder einen Löt- bzw. Sinterclip 120. Dabei ist das eine Ende des Bonddrahtes bzw. - bändchen 110 oder des Löt- bzw. Sinterclips 120 mit einem Bereich der Oberseite 101 des Trägerelementes elektrisch kontaktiert. Das andere Ende des Bonddrahtes bzw. -bändchen 110 oder des Löt- bzw. Sinterclips 120 ist mit der ersten bzw. der zweiten Kontaktstelle 24, 25 der Leiterstruktur 21 elektrisch kontaktiert. In diesen Fällen sind die erste und/oder die zweite Kontaktstelle 24, 25 in Bezug zum Trägerelement 100 bevorzugt in einem Abstand auf dem Schaltungsträger 20 angeordnet.

Eine alternative Verbindungsmöglichkeit ist durch ein Durchkontaktierung 105 gegeben. Hierbei ist ausgehend von einem Bereich der Oberseite 101 des Trägerelementes100 eine Durchgangskontaktierung 105 durch das Trägerelement 100 hindurch ausgebildet. Die Durchgangskontaktierung 105 reicht dabei bis zur einer elektrischen Kontaktierung der ersten bzw. zweiten Kontaktstelle 24, 25 der Leiterstruktur 21. Im Falle einer Lotschicht 300 oder alternativ einer Sinterschicht oder einer leitfähigen Kleberschicht kann die Durchkontaktierung 105 auch nur bis zu einer dieser Schichten reichen. Dabei ist vorauszusetzen, dass einer dieser Schichten mit der ersten bzw. mit der zweiten Kontaktstelle 24, 25 der Leiterstruktur 21 elektrisch kontaktiert ist.

Die beschriebenen Verbindungsmöglichkeiten über einen Bonddraht bzw. - bändchen 110, über einen Löt- bzw. Sinterclip 120 oder über eine Durchkontaktierung 105 können jeweils ausschließlich für eine elektrische Verbindung der ersten bzw. zweiten Kontaktstelle 24, 25 der Leiterstruktur 21 mit dem ersten bzw. zweiten Anschlussbereich 51, 52 des elektrischen und/oder elektronischen Bauelementes 50 vorgesehen werden. Ebenso ist nur eine jeweils einseitige elektrische Verbindung durch eine der beschriebenen Verbindungsmöglichkeiten realisierbar.

Bei einer jeweils einseitigen elektrischen Verbindung sind alle möglichen Kombinationen von zwei Verbindungsmöglichkeiten ausführbar. So ist beispielsweise eine einseitige elektrische Verbindung mit einem Drahtbond bzw. -bändchen 110 kombinierbar mit einer einseitigen elektrischen Verbindung mit einem Löt- bzw. Sinterclip 120 oder einer Durchkontaktierung 105. Ebenso ist eine einseitige elektrische Verbindung mit einem Löt- bzw. Sinterclip 120 kombinierbar mit einer einseitigen elektrischen Verbindung mit einer Durchkontaktierung 105. Die verschiedenen Verbindungsmöglichkeiten können den Darstellungen in den Fig. 2.1 - 2.15 ersehen werden.

## Patentansprüche

1. Schaltungsanordnung (15) umfassend zumindest einen Schaltungsträger (20) mit zumindest einer auf dem Schaltungsträger (20) ausgebildeten Leiterstruktur (21), wobei die Leiterstruktur (21) zumindest eine erste und eine zweite elektrische Kontaktstelle (24, 25) aufweist, und zumindest ein elektrisches und/oder elektronisches Bauelement (50) mit zumindest einem ersten und einem zweiten Anschlussbereich (51, 52), wobei zur Ausbildung einer Schaltung die zumindest erste Kontaktstelle (24) der Leiterstruktur (21) mit dem zumindest ersten elektrischen Anschlussbereich (51) des elektrischen und/oder elektronischen Bauelements (50) und/oder wobei die zumindest zweite Kontaktstelle (25) der Leiterstruktur (21) mit dem zumindest zweiten Anschlussbereich (52) des elektrischen und/oder elektronischen Bauelementes (50) mittelbar oder unmittelbar elektrisch verbunden ist/sind,
**dadurch gekennzeichnet, dass**
das zumindest eine elektrische und/oder elektronische Bauelement (50) zur Reduzierung einer Übertragung mechanischer Belastungen von dem zumindest einen Schaltungsträger (20) auf zumindest einem Trägerelement (100) angeordnet ist und über das zumindest eine Trägerelement (100) mittelbar mit dem zumindest einen Schaltungsträger (20) verbunden ist, indem das zumindest eine Trägerelement (100) mit dem zumindest einen Schaltungsträger (20) verbunden ist, wobei das Trägerelement eine größere Zug- , Druck- und/oder Biegefestigkeit aufweist als das zumindest eine elektrische und/oder elektronische Bauelement.

2. Schaltungsanordnung (15) nach Anspruch 1,
**dadurch gekennzeichnet, dass**
das zumindest eine elektrische und/oder elektronische Bauelement (50) ein SMD-Bauelement ist, beispielsweise ein NTC oder ein MLCC.

3. Schaltungsanordnung (15) nach einem der Ansprüche 1 oder 2,
**dadurch gekennzeichnet, dass**
der Schaltungsträger (20) ein Stanzgitter, ein DBC, ein AMB, ein IMS oder ein PCB ist.

4. Schaltungsanordnung (15) nach einem der vorhergehenden Ansprüche,
**dadurch gekennzeichnet, dass**
das zumindest eine Trägerelement (100) aus einem organischen Material, beispielsweise einem Polymermaterial, bevorzugt aus einem Faser-Kunststoff-Verbund, oder aus einem keramischen Material, beispielsweise aus Si3N4, AIN, ZTA, SiO2, B2O3, PBO, Na2O, K2O, Li2O, CaO, MgO, ZnO und/oder aus Al2O3, gebildet ist.

5. Schaltungsanordnung (15) nach einem der vorhergehenden Ansprüche,
**dadurch gekennzeichnet, dass**
das zumindest eine Trägerelement (100) als elektrische Isolation zwischen dem zumindest einen elektrischen und/oder elektronischen Bauelement (50) und dem zumindest einen Schaltungsträger (20) ausgebildet ist.

6. Schaltungsanordnung (15) nach einem der vorhergehenden Ansprüche,
**dadurch gekennzeichnet, dass**
das zumindest eine Trägerelement (100) plattenartig ausgebildet ist, bevorzugt mit einer Dicke von 50µm bis 5 mm, wobei das zumindest eine elektrische und/oder elektronische Bauelement (50) auf einer Oberseite (101) des Trägerelementes (100) angeordnet ist und eine Unterseite (102) des Trägerelementes (100) zumindest bereichsweise mit dem zumindest einen Schaltungsträger (20) verbunden ist.

7. Schaltungsanordnung (15) nach einem der vorhergehenden Ansprüche,
**dadurch gekennzeichnet, dass**
der zumindest eine Schaltungsträger (20) zwischen der ersten und der zweiten Kontaktstelle (24, 25) der Leiterstruktur (21) eine Aussparung (28), insbesondere in Form eines Durchbruches, aufweist und die Aussparung (28) in zumindest einem Bereich durch das zumindest eine Trägerelement (100) überbrückt ist.

8. Schaltungsanordnung (15) nach Anspruch 7,
**dadurch gekennzeichnet, dass**
die Aussparung (28) eine Längserstreckung aufweist, insbesondere aufgrund einer rechteckigen Grundform, und das zumindest eine elektrische und/oder elektronische Bauelement (50) in Richtung der Längserstreckung oder quer zu dieser auf dem zumindest einen Trägerelement (100) angeordnet ist.

9. Schaltungsanordnung (15) nach einem der Ansprüche 7 oder 8,
**dadurch gekennzeichnet, dass**
die Aussparung (28) durch einen Spalt zwischen zwei benachbarten Bereichen eines Stanzgitters (100) gebildet ist und die zwei benachbarten Bereiche jeweils die erste bzw. die zweite Kontaktstelle (24, 25) aufweisen.

10. Schaltungsanordnung (15) nach einem der Ansprüche 7 bis 9,
**dadurch gekennzeichnet, dass**
die Aussparung (28) durch mindestens zwei, bevorzugt parallel zueinander angeordneten, Trägerelemente (100) überbrückt ist, wobei das zumindest eine elektrische und/oder elektronische Bauelement (50) auf dem ersten und auf dem zweiten Trägerelement (100) angeordnet ist.

11. Schaltungsanordnung (15) nach einem der vorhergehenden Ansprüche,
**dadurch gekennzeichnet, dass**
das zumindest eine Trägerelement (100) mittels einer Lot-, Sinter- oder Kleberschicht (300) mit dem zumindest einen Schaltungsträger verbunden ist.

12. Schaltungsanordnung (15) nach einem der vorhergehenden Ansprüche,
**dadurch gekennzeichnet, dass**
das zumindest eine elektrische und/oder elektronische Bauelement (50) mittels einer Lot-, Sinter- oder Kleberschicht mit dem zumindest einen Trägerelement verbunden ist.

13. Schaltungsanordnung (15) nach einem der vorhergehenden Ansprüche,
**dadurch gekennzeichnet, dass**
die zumindest erste und/oder die zweite Kontaktstelle (24, 25) der Leiterstruktur (21) und/oder der zumindest erste und/oder zweite Anschlussbereich (51, 52) des zumindest einen elektrischen und/oder elektronischen Bauelements (50) mittels einer Draht- bzw. Bändchenbondtechnik, einer Cliplötung bzw. -sinterung und/oder einer Durchkontaktierung (105) elektrisch kontaktiert ist/sind, wobei die Durchkontaktierung (105) in dem zumindest einen Trägerelement ausgebildet ist.

14. Schaltungsanordnung (15) nach Anspruch 13,
**dadurch gekennzeichnet, dass**
das zumindest eine Trägerelement (100) zumindest einen Kontaktbereich aufweist, welcher mit der zumindest ersten Kontaktstelle (24) und/oder mit der zweiten Kontaktstelle (25) der Leiterstruktur (21) und/oder mit dem zumindest ersten und/oder mit dem zweiten Anschlussbereich (51, 52) des zumindest einen elektrischen und/oder elektronischen Bauelements (50) elektrisch kontaktiert ist, insbesondere mittels eines gebondenen Drahtes (110) oder Bändchen (110), eines gelöteten oder versinterten Clips (120) und/oder einer Durchkontaktierung (105), wobei die Durchkontaktierung (105) in dem zumindest einen Trägerelement (100) ausgebildet ist

15. Leistungsmodul (10) mit einer Schaltungsanordnung (15) nach einem der Ansprüche 1 bis 14 und zumindest einem Leistungshalbleiter (40), insbesondere basierend auf einer SiC - Technologie, wobei das zumindest eine elektrische und/oder elektronische Bauelement (50) der Schaltungsanordnung (15) ein Kondensator in SMD-Technik ist, insbesondere ein MLCC-Kondensator, welcher zur Minimierung parasitärer Induktivitäten in unmittelbarer Nähe zum Leistungshalbleiter (40) angeordnet ist.

## Claims

1. Circuit arrangement (15) comprising at least one circuit carrier (20) having at least one conductor structure (21) formed on the circuit carrier (20), wherein the conductor structure (21) has at least one first and one second electrical contact point (24, 25), and at least one electrical and/or electronic component (50) having at least one first and one second connection region (51, 52), wherein, to form a circuit, the at least first contact point (24) of the conductor structure (21) is directly or indirectly electrically connected to the at least first electrical connection region (51) of the electrical and/or electronic component (50) and/or wherein the at least second contact point (25) of the conductor structure (21) is directly or indirectly electrically connected to the at least second connection region (52) of the electrical and/or electronic component (50),
**characterized in that**
the at least one electrical and/or electronic component (50) is arranged to reduce transmission of mechanical loads from the at least one circuit carrier (20) to at least one carrier element (100) and is indirectly connected to the at least one circuit carrier (20) by means of the at least one carrier element (100) by virtue of the at least one carrier element (100) being connected to the at least one circuit carrier (20), wherein the carrier element has a greater tensile, compressive and/or flexural strength than the at least one electrical and/or electronic component.

2. Circuit arrangement (15) according to Claim 1,
**characterized in that**
the at least one electrical and/or electronic component (50) is an SMD component, for example an NTC or an MLCC.

3. Circuit arrangement (15) according to either of Claims 1 and 2,
**characterized in that**
the circuit carrier (20) is a lead frame, a DBC, an AMB, an IMS or a PCB.

4. Circuit arrangement (15) according to one of the preceding claims,
**characterized in that**
the at least one carrier element (100) is formed from an organic material, for example a polymer material, preferably from a fibre/plastic composite, or from a ceramic material, for example from Si3N4, AlN, ZTA, SiO2, B2O3, PBO, Na2O, K2O, Li2O, CaO, MgO, ZnO and/or from Al2O3.

5. Circuit arrangement (15) according to one of the preceding claims,
**characterized in that**
the at least one carrier element (100) is formed as an electrical insulation between the at least one electrical and/or electronic component (50) and the at least one circuit carrier (20).

6. Circuit arrangement (15) according to one of the preceding claims,
**characterized in that**
the at least one carrier element (100) is of plate-like form, preferably having a thickness of 50 µm to 5 mm, wherein the at least one electrical and/or electronic component (50) is arranged on a top side (101) of the carrier element (100) and a bottom side (102) of the carrier element (100) is connected at least in regions to the at least one circuit carrier (20).

7. Circuit arrangement (15) according to one of the preceding claims,
**characterized in that**
the at least one circuit carrier (20) has a recess (28), in particular in the form of an aperture, between the first and the second contact point (24, 25) of the conductor structure (21) and the recess (28) is bridged by the at least one carrier element (100) in at least one region.

8. Circuit arrangement (15) according to Claim 7,
**characterized in that**
the recess (28) has a longitudinal extent, in particular on account of a rectangular basic form, and the at least one electrical and/or electronic component (50) is arranged on the at least one carrier element (100) in the direction of the longitudinal extent or transversely thereto.

9. Circuit arrangement (15) according to either of Claims 7 and 8,
**characterized in that**
the recess (28) is formed by a gap between two adjacent regions of a lead frame (100) and the two adjacent regions respectively have the first and the second contact point (24, 25).

10. Circuit arrangement (15) according to one of Claims 7 to 9,
**characterized in that**
the recess (28) is bridged by at least two carrier elements (100), which are preferably arranged parallel to one another, wherein the at least one electrical and/or electronic component (50) is arranged on the first and on the second carrier element (100).

11. Circuit arrangement (15) according to one of the preceding claims,
**characterized in that**
the at least one carrier element (100) is connected to the at least one circuit carrier by means of a solder, sinter or adhesive layer (300).

12. Circuit arrangement (15) according to one of the preceding claims,
**characterized in that**
the at least one electrical and/or electronic component (50) is connected to the at least one carrier element by means of a solder, sinter or adhesive layer.

13. Circuit arrangement (15) according to one of the preceding claims,
**characterized in that**
the at least first and/or the second contact point (24, 25) of the conductor structure (21) and/or the at least first and/or second connection region (51, 52) of the at least one electrical and/or electronic component (50) is/are electrically contacted by means of wire or ribbon bonding technology, clip soldering or sintering and/or a via (105), wherein the via (105) is formed in the at least one carrier element.

14. Circuit arrangement (15) according to Claim 13,
**characterized in that**
the at least one carrier element (100) has at least one contact region, which is electrically contact-connected to the at least first contact point (24) and/or to the second contact point (25) of the conductor structure (21) and/or to the at least first and/or to the second connection region (51, 52) of the at least one electrical and/or electronic component (50), in particular by means of a bonded wire (110) or ribbon (110), a soldered or sintered clip (120) and/or a via (105), wherein the via (105) is formed in the at least one carrier element (100).

15. Power module (10) having a circuit arrangement (15) according to one of Claims 1 to 14 and at least one power semiconductor (40), in particular based on SiC technology, wherein the at least one electrical and/or electronic component (50) of the circuit arrangement (15) is a capacitor in SMD technology, in particular an MLCC capacitor, which is arranged immediately next to the power semiconductor (40) to minimize parasitic inductances.

## Revendications

1. Circuit (15) comprenant au moins un support de circuit (20) muni d'au moins une structure conductrice (21) réalisée sur le support de circuit (20), dans lequel la structure conductrice (21) comporte au moins un premier et un second point de contact électrique (24, 25) et au moins un composant électrique et/ou électronique (50) muni d'au moins une première et une seconde zone de connexion (51, 52), dans lequel, pour réaliser un circuit, ledit au moins premier point de contact (24) de la structure conductrice (21) est/sont directement ou indirectement relié(s) électriquement à ladite au moins première zone de connexion électrique (51) du composant électrique et/ou électronique (50) et/ou dans lequel ledit au moins second point de contact (25) de la structure conductrice (21) est/sont indirectement ou directement relié(s) électriquement à ladite au moins seconde zone de connexion (52) du composant électrique et/ou électronique (50),
**caractérisé en ce que** ledit au moins un composant électrique et/ou électronique (50) est disposé sur au moins un élément porteur (100) pour réduire la transmission de charges mécaniques à partir dudit au moins un support de circuit (20) et est indirectement relié audit au moins un support de circuit (20) par l'intermédiaire dudit au moins un élément porteur (100) en reliant ledit au moins un élément porteur (100) audit au moins un support de circuit (20), dans lequel l'élément porteur présente une résistance à la traction, à la compression et/ou à la flexion supérieure à celle dudit au moins un composant électrique et/ou électronique.

2. Circuit (15) selon la revendication 1,
**caractérisé en ce que** ledit au moins un composant électrique et/ou électronique (50) est un composant SMD, par exemple un NTC ou un MLCC.

3. Circuit (15) selon l'une des revendications 1 ou 2,
**caractérisé en ce que** le support de circuit (20) est une grille découpée, un DBC, un AMB, un IMS ou un PCB.

4. Circuit (15) selon l'une des revendications précédentes,
**caractérisé en ce que** ledit au moins un élément porteur (100) est constitué d'un matériau organique, par exemple d'un matériau polymère, de préférence d'un composite fibre-plastique, ou d'un matériau céramique, par exemple de Si3N4, d'AlN, de ZTA, de SiO2, de B2O3, de PBO, de Na2O, de K2O, de Li2O, de CaO, de MgO, de ZnO et/ou d'Al2O3.

5. Circuit (15) selon l'une des revendications précédentes,
**caractérisé en ce que** ledit au moins un élément porteur (100) est réalisé sous la forme d'une isolation électrique entre ledit au moins un composant électrique et/ou électronique (50) et ledit au moins un support de circuit (20).

6. Circuit (15) selon l'une des revendications précédentes,
**caractérisé en ce que** ledit au moins un élément porteur (100) est réalisé sous forme de plaque, de préférence d'une épaisseur allant de 50 µm à 5 mm, dans lequel au moins un composant électrique et/ou électronique (50) est disposé sur une face supérieure (101) de l'élément porteur (100) et une face inférieure (102) de l'élément porteur (100) est reliée au moins par zones audit au moins un support de circuit (20).

7. Circuit (15) selon l'une des revendications précédentes,
**caractérisé en ce que** ledit au moins un support de circuit (20) présente un évidement (28) entre le premier et le second point de contact (24, 25) de la structure conductrice (21), notamment sous forme de traversée et **en ce que** l'évidement (28) est ponté dans au moins une zone par au moins un élément porteur (100).

8. Circuit (15) selon la revendication 7,
**caractérisé en ce que** l'évidement (28) présente une étendue longitudinale, notamment du fait d'une forme de base rectangulaire, et **en ce que** ledit au moins un composant électrique et/ou électronique (50) est disposé sur ledit au moins un élément porteur (100) dans le sens de l'extension longitudinale ou transversalement à celle-ci.

9. Circuit (15) selon l'une des revendications 7 ou 8,
**caractérisé en ce que** l'évidement (28) est formé par un interstice entre deux zones adjacentes d'une grille découpée (100) et **en ce que** les deux zones adjacentes présentent respectivement les premier et second points de contact (24, 25).

10. Circuit (15) selon l'une des revendications 7 à 9,
**caractérisé en ce que** l'évidement (28) est ponté par au moins deux éléments porteurs (100), de préférence disposés parallèlement l'un à l'autre, dans lequel ledit au moins un composant électrique et/ou électronique (50) est disposé sur le premier et sur le second élément porteur (100).

11. Circuit (15) selon l'une des revendications précédentes,
**caractérisé en ce que** ledit au moins un élément porteur (100) est relié audit au moins un support de circuit au moyen d'une couche de soudure, de frittage ou de colle (300).

12. Circuit (15) selon l'une des revendications précédentes,
**caractérisé en ce que** ledit au moins un composant électrique et/ou électronique (50) est relié audit au moins un élément porteur au moyen d'une couche de soudure, de frittage ou de colle.

13. Circuit (15) selon l'une des revendications précédentes,
**caractérisé en ce que** ledit au moins un premier et/ou second point de contact (24, 25) de la structure conductrice (21) et/ou ladite au moins une première et/ou seconde région de connexion (51, 52) dudit au moins un composant électrique et/ou électronique (50) est/sont électriquement connecté(s) par une technique de soudage par fils ou rubans, de soudage par clips, de frittage et/ou de contact traversant (105), dans lequel le contact traversant (105) est réalisé dans ledit au moins un élément porteur.

14. Circuit (15) selon la revendication 13,
**caractérisé en ce que** ledit au moins un élément porteur (100) présente au moins une zone de contact qui est mise en contact électrique avec ledit au moins un premier point de contact (24) et/ou avec le second point de contact (25) de la structure conductrice (21) et/ou avec ladite au moins une première zone de connexion et/ou avec la seconde zone de connexion (51, 52) dudit au moins un composant électrique et/ou électronique (50), notamment au moyen d'un fil (110) ou d'un ruban (110) soudés, d'un clip (120) soudé ou fritté et/ou d'un contact traversant (105), dans lequel le contact traversant (105) est réalisé dans ledit au moins un élément porteur (100).

15. Module de puissance (10) comprenant un circuit (15) selon l'une des revendications 1 à 14 et au moins un semi-conducteur de puissance (40), qui est notamment basé sur la technologie SiC, dans lequel ledit au moins un composant électrique et/ou électronique (50) du circuit (15) est un condensateur en technologie SMD, notamment un condensateur MLCC, qui est disposé à proximité immédiate du semi-conducteur de puissance (40) afin de minimiser les inductances parasites.
